# EUROPÄISCHE PATENTSCHRIFT

(11) **EP 3 116 042 B1**
(45) Veröffentlichungstag und Bekanntmachung des Hinweises auf die Patenterteilung: **28.11.2018**
(21) Anmeldenummer: 16176820.5
(22) Anmeldetag: 29.06.2016
(51) Int. Cl.: H01L 41/047, F02M 51/06

(54) **PIEZOAKTORMODUL UND PIEZOINJEKTOR**
PIEZOACTUATOR MODULE AND PIEZO INJECTOR
MODULE DE PIEZOACTEUR ET PIEZOINJECTEUR

(30) Priorität: 10.07.2015 DE 102015213003
(43) Veröffentlichungstag der Anmeldung: 11.01.2017
(73) Patentinhaber: ROBERT BOSCH GMBH, 70442 Stuttgart (DE)
(72) Erfinder: Kreschel, Henning, 71640 Ludwigsburg (DE); Rapp, Holger, 71254 Ditzingen (DE)

(56) Entgegenhaltungen:
- EP-A1- 3 109 911
- WO-A1-01/91199
- DE-A1-102004 015 574
- DE-A1-102008 003 840
- JP-A- 2011 003 574

## Beschreibung

### Stand der Technik

Die Erfindung betrifft ein Piezoaktormodul nach dem Oberbegriff des Anspruchs 1. Ferner betrifft die Erfindung einen Piezoinjektor mit einem erfindungsgemäßen Piezoaktormodul.

Ein Piezoaktormodul nach dem Oberbegriff des Anspruchs 1 ist aus der DE 10 2008 003 838 A1 der Anmelderin bekannt. Das bekannte Piezoaktormodul dient als Bestandteil eines Piezoinjektors zum Einspritzen von Kraftstoff in einen Brennraum einer insbesondere selbstzündenden Brennkraftmaschine. Das bekannte Piezoaktormodul zeichnet sich dadurch aus, dass sich ein Piezoaktor, der eine Vielzahl von übereinander gestapelten Piezokeramikschichten aufweist, über Kontaktmittel elektrisch ansteuerbar ist, um dessen axiale Länge bzw. Erstreckung zu verändern. Dadurch lässt sich zumindest indirekt die Stellung eines in dem Piezoinjektor angeordneten Einspritzglieds (Düsennadel) verändern, um das Einspritzen von Kraftstoff in den Brennraum der Brennkraftmaschine zu steuern. Da die Piezokeramik und die Aktorelektroden nicht direkt mit dem Kraftstoff in Berührung kommen sollten, der Aktor aber zur Erfüllung seiner Funktion üblicherweise in einem mit Kraftstoff befüllten Volumen angeordnet werden muss, ist der Piezoaktor in einem Piezoaktorgehäuse angeordnet, das aus einem Aktorfuß, einer Schutzhülse und einem Aktorkopf besteht, wobei die genannten Bauteile dicht miteinander verbunden sind, um den Eintritt von Kraftstoff in das Piezoaktorgehäuse zu vermeiden. Der Piezoaktor ist im Bereich der Schutzhülse mit radialem Spiel angeordnet und von einer elastischen Vergussmasse umgeben, die beim Betrieb der Wärmeübertragung dient. Die elektrische Kontaktierung des Piezoaktors erfolgt über Kontaktmittel in Form von Anschlußdrähten, die durch den Aktorfuß hindurchgeführt und dort abgedichtet angeordnet sind. Dabei kommen üblicherweise zwei, in Bezug auf eine Längsachse des Piezoaktors um 180° zueinander versetzt angeordnete Anschlußdrähte zur Anwendung, deren aus dem Aktorfuß heraustretende Abschnitte (die auch als Anschlusspins bezeichnet werden) an gegenüberliegend an der Umfangsfläche des Piezoaktors angeordneten Kontaktflächen über Schweißverbindungen mit dem Piezoaktor verbunden sind. Insbesondere während der Fertigung, aber auch aufgrund sonstiger Umstände, kann es zu minimalen Relativbewegungen zwischen dem Aktorfuß und dem Piezoaktor kommen, welche insbesondere den Abstand zwischen den Anschlußdrähten im Austrittsbereich aus dem Aktorfuß und der jeweiligen, die Schweißverbindung aufweisende Kontaktfläche am Piezoaktor verändern. Dadurch kann es entweder zu einer Vorschädigung oder aber zu einem Abreißen eines Anschlussdrahtes im Bereich zwischen dem Aktorfuß und der Schweißverbindung mit dem Piezoaktor kommen, da die in dem Anschlussdraht zwischen dem Aktorfuß und der Kontaktstelle auftretenden mechanischen Zugspannungen den Anschlussdraht überlasten können. Reißt der Anschlussdraht ab, so ist die elektrische Kontaktierung des Piezoaktors nicht mehr intakt, der Aktor kann nicht mehr angesteuert werden und der Piezoinjektor kann keinen Kraftstoff mehr in den Brennraum der Brennkraftmaschine einspritzen.

Aus WO 2001/091199 A1, DE 10 2004 015 574 A1, DE 10 2008 003 840 A1, EP 3 109 911 A1 und JP 2011-003574 A sind darüber hinaus Piezoaktormodule bekannt, die eine Vielzahl von Schichtelektroden aufweisen, die mittels Elektroden kontaktiert sind. Dabei sind die Elektroden auf Seitenflächen des Piezoaktors aufgebracht.

### Offenbarung der Erfindung

Ausgehend von dem dargestellten Stand der Technik liegt der Erfindung die Aufgabe zugrunde, ein Piezoaktormodul nach dem Oberbegriff des Anspruchs 1 derart weiterzubilden, dass dieses mit Blick auf etwaige Relativbewegungen zwischen dem Aktorfuß und dem Piezoaktor besonders robust bzw. unempfindlich ausgebildet ist. Unter einer besonders robusten Ausbildung wird dabei eine zuverlässige elektrische Kontaktierung des Piezoaktors über die Kontaktmittel verstanden, wobei auch beim Auftreten der angesprochenen Relativbewegungen keine unzulässig hohen Spannungen bzw. Kräfte auf die Kontaktmittel einwirken sollen.

Diese Aufgabe wird erfindungsgemäß bei einem Piezoaktormodul mit den kennzeichnenden Merkmalen des Anspruchs 1 dadurch gelöst, dass die Kontaktflächen des Piezoaktors im Bereich der mit diesen verbundenen Kontaktmittel beweglich angeordnet sind. Mit anderen Worten gesagt bedeutet dies, dass durch die bewegliche Anordnung der Kontaktflächen mit den mit diesen verbundenen Kontaktmitteln eine Relativbewegung zwischen dem Piezoaktor und den Kontaktmitteln ermöglicht wird, die über die beweglichen Kontaktflächen ausgeglichen wird. Dadurch werden insbesondere zu hohe Zugspannungen, die zu einer Vorschädigung oder Beschädigung der Kontaktstellen und/oder der Kontaktmittel führen, vermieden.

Erfindungsgemäß wird eine besonders sichere und zuverlässige Verbindung der Elektrodenschichten mit den Kontaktmitteln erzielt, indem der Piezoaktor an seiner Umfangsfläche mit den Elektrodenschichten elektrisch leitend verbundene Metallisierungsschichten aufweist, und wenn die Metallisierungsschichten auf der den Piezoaktor abgewandten Seite zumindest bereichsweise mit einem elektrisch leitenden, flexiblen Metallgitter verbunden sind, wobei das Metallgitter die Kontaktflächen ausbildet.

Dabei ist erfindungsgemäß eine physische Trennung zwischen der Metallisierungsschicht und dem Metallgitter vorgesehen, indem zumindest im Bereich der Kontaktflächen zwischen der Metallisierungsschicht und dem Metallgitter eine Trennschicht angeordnet ist, die eine Verbindung zwischen der Metallisierungsschicht und dem Metallgitter verhindert. Da die Verbindung zwischen den Kontaktmitteln und dem Metallgitter üblicherweise in Form einer stoffschlüssigen Verbindung (insbesondere einer Schweißverbindung), d.h. unter Wärmeeintrag erfolgt, ist es wichtig, dass die Trennschicht der beim Ausbilden der Verbindung auftretenden thermischen Belastung standhält. Vor diesem Hintergrund und aus dem Hintergrund einer guten Herstellbarkeit bzw. eines einfachen Aufbringens der Trennschicht im Bereich der Kontaktflächen ist es vorgesehen, dass die Trennschicht aus Kunststoff, insbesondere bestehend PTFE oder PEEK ausgebildet ist.

In Weiterbildung der ersten erfindungsgemäßen Variante ist es vorgesehen, dass die Metallisierungsschicht in einem Überdeckungsbereich mit den Kontaktmitteln eine Aussparung aufweist. Eine derartige Ausbildung bewirkt insbesondere, dass zumindest nahezu über die gesamte Höhe des Piezoaktors Elektrodenschichten angeordnet werden können, die über die Metallisierungsschicht mit den Kontaktmitteln verbunden werden können. Dadurch wird ein in der Höhe besonders kompakt bauendes Piezoaktormodul ermöglicht.

In einer gegenüber den zuletzt gemachten Vorschlag herstellungstechnisch vereinfachten Variante ist es vorgesehen, dass die Metallisierungsschicht ausschließlich außerhalb eines axialen Überdeckungsbereichs des Metallgitter mit den Kontaktmitteln an dem Piezoaktor ausgebildet ist. Mit anderen Worten gesagt bedeutet dies, dass die Metallisierungsschicht erst in einem gewissen Abstand von dem Aktorfuß an dem Piezoaktor ausgebildet wird.

Weiterhin umfasst die Erfindung einen Piezoinjektor, umfassend einen Haltekörper und einen in dem Haltekörper angeordnetes, soweit beschriebenes, erfindungsgemäßes Piezoaktormodul. Ein derartiger Piezoinjektor weist dieselben Vorteile auf, wie diese im Rahmen des Piezoaktormoduls erläutert wurden.

Weitere Vorteile, Merkmale und Einzelheiten der Erfindung ergeben sich aus der nachfolgenden Beschreibung bevorzugter Ausführungsbeispiele sowie anhand der Zeichnung.

Diese zeigt in:
- Fig. 1: einen Teilbereich eines Piezoinjektors mit einem erfindungsgemäßen Piezoaktormodul in einem vereinfachten Längsschnitt,
- Fig. 2: eine Seitenansicht auf einen bei dem Piezoinjektor gemäß Fig. 1 verwendeten Piezoaktor mit einer Metallisierungsschicht vor dem Aufbringen einer Metallgitterschicht,
- Fig. 3: den Piezoaktor gemäß Fig. 2 nach Aufbringen der Metallgitterschicht in Seitenansicht,
- Fig. 4: ein gegenüber Fig. 2 abgewandeltes Ausführungsbeispiel mit einer Aussparung in einer Metallisierungsschicht in Seitenansicht und
- Fig. 5: den Piezoaktor gemäß Fig. 4 nach dem Aufbringen einer Metallgitterschicht, ebenfalls in Seitenansicht.

Gleiche Elemente bzw. Elemente mit gleicher Funktion sind in den Figuren mit den gleichen Bezugsziffern versehen.

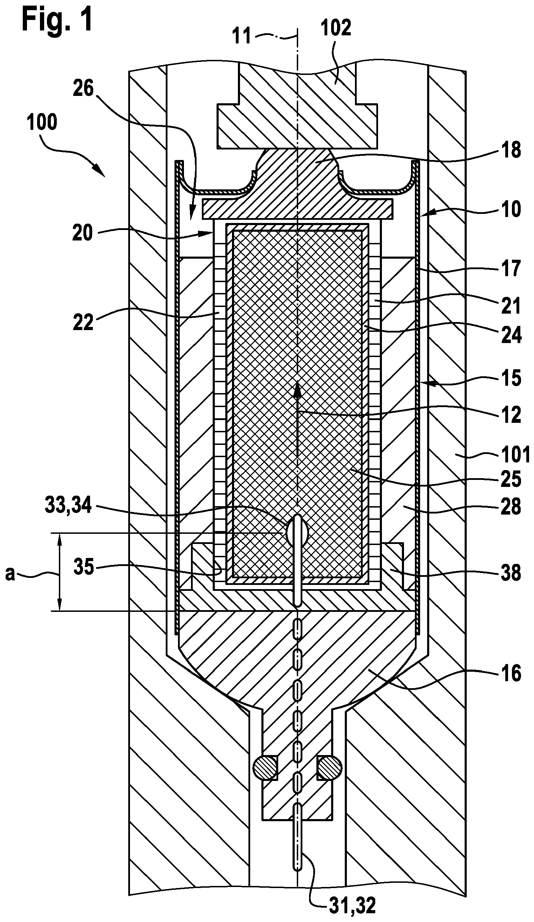

In der Fig. 1 ist ein Teilbereich eines Piezoinjektors 100 dargestellt, wie er insbesondere als Bestandteil eines sogenannten Common-Rail-Einspritzsystems zum Einspritzen von Kraftstoff in einen Brennraum in einer selbstzündenden Brennkraftmaschine dient. Der Piezoinjektor 100 weist einen Haltekörper 101 auf, in dessen Bereich ein Piezoaktormodul 10 angeordnet ist. Insbesondere kann es dabei vorgesehen sein, dass das Piezoaktormodul 10 innerhalb des Haltekörpers 101 mit radialem Spiel aufgenommen und von Kraftstoff umströmt ist. Ein Übertragungsglied 102, das mit dem Piezoaktormodul 10 in Wirkverbindung angeordnet ist, dient zur zumindest mittelbaren Bewegung eines in der Fig. 1 nicht dargestellten Einspritzglieds des Piezoinjektors 100, insbesondere in Form einer Düsennadel. Hierzu ist es vorgesehen, dass das Piezoaktormodul 10 aus der in der Fig. 1 gezeigten Ruhelage, in der das Piezoaktormodul 10 nicht bestromt ist, sich in Bezug auf eine Längsachse 11 des Piezoaktormoduls 10 in Richtung des Pfeils 12 (bei einer Bestromung) verlängert.

Das Piezoaktormodul 10 umfasst ein Piezoaktorgehäuse 15, das einen Aktorfuß 16, eine Schutzhülse 17 und einen Aktorkopf 18 aufweist. Die Schutzhülse 17 ist auf den gegenüberliegenden Seiten mit dem Aktorfuß 16 bzw. dem Aktorkopf 18 dichtend verbunden, um den Eintritt von Kraftstoff in den Innenraum des Piezoaktorgehäuses 15 zu vermeiden. Darüber hinaus ist der Aktorfuß 16 in Bezug zur Längsachse 11 in dem Haltekörper 101 fixiert aufgenommen, um eine Abstützung des Piezoaktormoduls 10 bei einer Verlängerung desselben und eine Kraftübertragung auf das Übertragungsglied 102 zu ermöglichen. Eine derartige Abstützung kann beispielsweise durch den Haltekörper 101 durch axiale Anlage des Piezoaktormoduls 10 an dem Haltekörper 101 erfolgen.

Das Piezoaktormodul 10 weist darüber hinaus einen aus einer Vielzahl von übereinander gestapelten Innenelektroden 21, 22 aufweisenden Piezoaktor 20 auf. Die Innenelektroden 21 bzw. 22 bilden zwei unterschiedliche Pole des Piezoaktors 20 aus und sind auf gegenüberliegenden Seiten jeweils untereinander elektrisch leitend verbunden. Hierzu dient eine in den Fig. 1 bis 3 erkennbare Metallisierungsschicht 24, die mit den jeweiligen Innenelektroden 21 bzw. 22 verbunden ist, wobei zwei Metallisierungsschichten 24 vorgesehen sind, die auf gegenüberliegenden Seiten des Piezoaktors 20 angeordnet sind.

Auf jeder der Metallisierungsschichten 24 ist ein Metallgitter 25 befestigt bzw. elektrisch leitend mit der Metallisierungsschicht 24 verbunden. Weiterhin ist der Piezoaktor 20, der sich in axialer Richtung der Längsachse 11 betrachtet zwischen dem Aktorfuß 16 und dem Aktorkopf 18 befindet, innerhalb der Schutzhülse 17 bzw. des Piezoaktorgehäuses 15 unter Ausbildung eines radialen Zwischenraums 26 in dem Piezoaktorgehäuse 15 angeordnet. Der radiale Zwischenraum 26 ist zumindest über einen Teilbereich der axialen Erstreckung des Piezoaktors 20, vorzugsweise zumindest nahezu bis in den Bereich des Aktorkopfes 18, von einer elastische Eigenschaften aufweisenden Vergussmasse 28 ausgefüllt.

Die elektrische Kontaktierung der untereinander über die Metallisierungsschicht 24 miteinander verbundenen Innenelektroden 21, 22 erfolgt mittels zweier Anschlussdrähte 31, 32, die Kontaktmittel ausbilden. Die Anschlussdrähte 31, 32 sind innerhalb des Aktorfußes 16 auf nicht gezeigte, an sich bekannte Weise abgedichtet geführt und beispielsweise von dem Steuergerät der Kraftstoffeinspritzanlage mit Strom bzw. Spannung versorgbar. Die Anschlussdrähte 31, 32 sind im Bereich von Kontaktflächen 33 mit dem Metallgitter 25 über Schweißverbindungen 34 starr verbunden. Die Kontaktflächen 33 weisen in Bezug zur Längsachse 11 einen Abstand a zum Aktorfuß 16 auf. Darüber hinaus weist der Aktorfuß 16 eine radial um die Längsachse 11 verlaufende, unterbrochene Seitenwand 38 auf, die eine Aufnahme 35 für den Piezoaktor 20 ausbildet, der innerhalb der Aufnahme 35 mit lediglich geringem radialen Montagespiel angeordnet ist.

Um eine Relativbewegung zwischen dem Aktorfuß 16 und dem Piezoaktor 20 zu ermöglichen, ist es vorgesehen, dass das Metallgitter 25 zumindest im Bereich der Kontaktflächen 33 nicht mit der Metallisierungsschicht 24 verbunden ist, wobei die Kontaktfläche 33 eine größere Ausdehnung aufweist als die Schweißverbindung 34. Dadurch besteht die Möglichkeit, dass sich das Metallgitter 25 bei einer über den Anschlussdraht 31, 32 und die Schweißverbindung 34 auf die Kontaktfläche 33 des Metallgitters 25 übertragene Kraft deformiert bzw. verformt und somit in dem Anschlussdraht 31, 32 auftretende mechanische Spannungen reduziert werden.

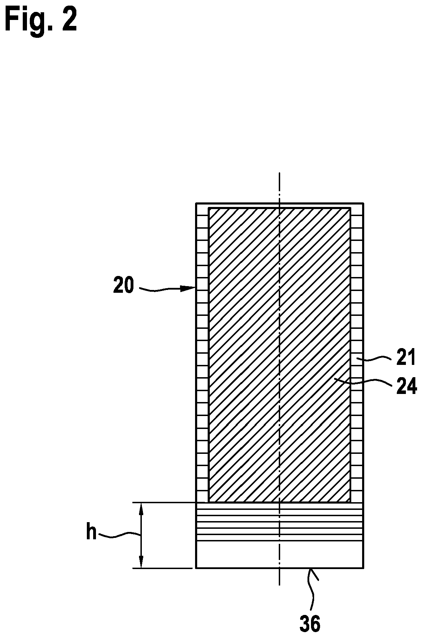

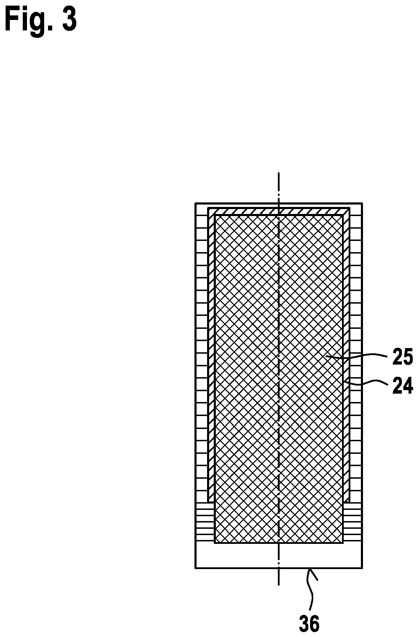

So ist bei dem in den Fig. 2 und 3 dargestellten Ausführungsbeispiel, die zwei aufeinanderfolgende Herstellungsphasen bei der Herstellung des Piezoaktors 20 zeigt, vorgesehen, dass die Metallisierungsschicht 24 lediglich über einen Teilbereich der Höhe des Piezoaktors 20 ausgebildet ist. Insbesondere beginnt die Metallisierungsschicht 24 erst in einer Höhe h in Bezug zu einer unteren Stirnfläche 36 des Piezoaktors 20, wobei die Höhe h über die noch auszubildende Verbindung zwischen dem Anschlussdraht 31, 32 im Bereich der Kontaktfläche 33 axial hinausragt, d.h. mindestens dem Abstand a entspricht, vorzugsweise größer ist als der Abstand a. In einem nachfolgenden Fertigungsschritt wird anschließend das rechteckförmige Metallgitter 25 in Überdeckung mit der Metallisierungsschicht 24 gebracht und mit dieser (vollflächig) verbunden, derart, dass das Metallgitter 25 zumindest nahezu bis in den Bereich der Stirnfläche 36 des Piezoaktors 20 reicht. Anschließend wird in einem weiteren Schritt der jeweilige Anschlussdraht 31, 32 im Bereich der Kontaktfläche 33, die sich in dem Bereich des Piezoaktors 20 befindet, in dem keine Metallisierungsschicht 24 ausgebildet ist, mit dem Metallgitter 25 verbunden (nicht dargestellt).

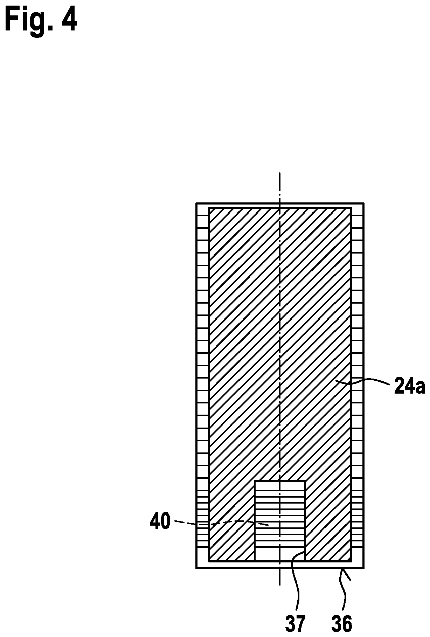

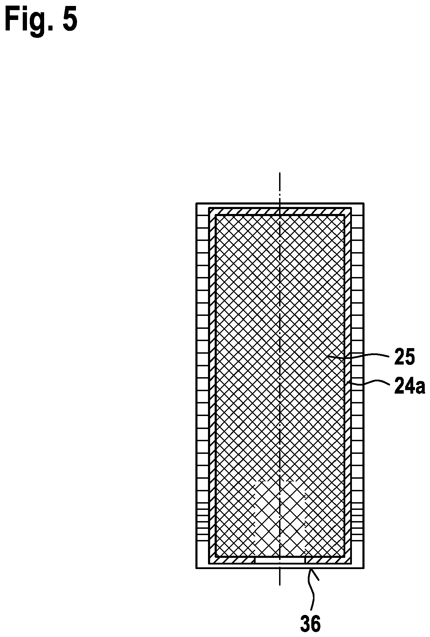

Bei dem in den Fig. 4 und 5 dargestellten Ausführungsbeispiel weist die Metallisierungsschicht 24a, welche zumindest nahezu über die gesamte Höhe des Piezoaktors 20 reicht, eine in etwa rechteckförmige Aussparung 37 auf, in deren Bereich keine Metallisierungsschicht 24 aufgebracht ist. Die Aussparung 37 reicht von der unteren Stirnseite 36 des Piezoaktors 20 bis in eine Höhe zumindest im Bereich der Kontaktfläche 33, vorzugsweise axial über die Kontaktfläche 33 hinaus. In dem in der Fig. 5 dargestellten Fertigungsschritt ist auf die Metallisierungsschicht 24a das Metallgitter 25 aufgebracht und mit der Metallisierungsschicht 24a vollflächig verbunden, wobei das Metallgitter 25 den Bereich der Aussparung 37 überdeckt. Zuletzt wird der jeweilige Anschlussdraht 31, 32 im Bereich der Aussparung 37, in deren Bereich auch die Kontaktfläche 33 angeordnet ist, mit dem Metallgitter 25 verbunden (nicht dargestellt).

In einer weiteren, im Einzelnen nicht dargestellten Ausführungsform der Erfindung kann es vorgesehen sein, dass zumindest im Bereich der Kontaktflächen 33, also beispielsweise im Bereich der Aussparung 37 (in Bezug auf die Fig. 4 und 5) oder in dem Bereich zwischen der Stirnfläche 36 und der Metallisierungsschicht 24 (in Bezug auf die Fig. 2 und 3) eine insbesondere aus Kunststoff, vorzugsweise aus PTFE oder PEEK bestehende Schicht 40 auf die Metallisierungsschicht 24 aufgebraucht wird und dass anschließend auf diese Schicht wiederum das Metallgitter 25 aufgebracht wird, wobei eine Ankopplung bzw. Verbindung zwischen dem Metallgitter 25 und der angesprochenen, als Trennschicht wirkenden Kunststoffschicht vermieden wird, um auch dadurch eine Beweglichkeit des Metallgitters 25 zum Ausgleich von Relativbewegungen zwischen dem Aktorfuß 16 und dem Piezoaktor 20 zu vermeiden. In diesem Fall ist die Metallisierungsschicht 24, 24a im Gegensatz zu den gezeigten Ausführungsbeispielen über die gesamte Höhe des Piezoaktors 20 ausgebildet und von dem Metallgitter 25 überdeckt.

Das soweit beschriebene Piezoaktormodul 10 bzw. der Piezoinjektor 100 können in vielfältiger Art und Weise abgewandelt bzw. modifiziert werden, ohne vom Erfindungsgedanken abzuweichen.

## Patentansprüche

1. Piezoaktormodul (10), mit einem Aktorfuß (16), einem Aktorkopf (18) und einem zwischen dem Aktorfuß (16) und dem Aktorkopf (18) angeordneten Piezoaktor (20) aus einer Vielzahl von Elektrodenschichten (21, 22), wobei der Piezoaktor (20) in Bezug zu einer Längsachse (11) des Piezoaktormoduls (10) sich an den Aktorfuß (16) anschließt, und wobei Kontaktmittel (31, 32) vorgesehen sind, die durch den Aktorfuß (16) hindurchgeführt und mit in einem Abstand (a) zum Aktorfuß (16) angeordneten Kontaktflächen (33) des Piezoaktors (20) starr verbunden sind, wobei der Piezoaktor (20) mit den Elektrodenschichten (21, 22) elektrisch leitend verbundene Metallisierungsschichten (24; 24a) am Umfang des Piezoaktors (20) aufweist, wobei die Metallisierungsschichten (24; 24a) auf der dem Piezoaktor (20) abgewandten Seite zumindest bereichsweise mit elektrisch leitenden, flexiblen Metallgittern (25) verbunden sind, wobei die Metallgitter (25) die Kontaktflächen (33) ausbilden die Kontaktflächen (33) im Bereich der mit diesen verbundenen Kontaktmittel (31,32) beweglich angeordnet sind,
**dadurch gekennzeichnet,**
**dass** zumindest im Bereich jeder Kontaktfläche (33) zwischen der Metallisierungsschicht (24; 24a) und dem Metallgitter (25) eine Trennschicht (40) angeordnet ist, die eine Verbindung zwischen der Metallisierungsschicht (24; 24a) und dem Metallgitter (25) verhindert.

2. Piezoaktormodul nach Anspruch 1,
**dadurch gekennzeichnet,**
**dass** die Metallisierungsschicht (24a) in einem axialen Überdeckungsbereich mit den Kontaktmitteln (31, 32) eine Aussparung (37) aufweist.

3. Piezoaktormodul nach Anspruch 1,
**dadurch gekennzeichnet,**
**dass** die Metallisierungsschicht (24) in einem axialen Bereich des Piezoaktors (20) ausgebildet ist, der sich in Bezug auf den Aktorfuß (16) an die Kontaktfläche (33) und außerhalb eines axialen Überdeckungsbereichs mit den Kontaktmitteln (31, 32) anschließt.

4. Piezoaktormodul nach Anspruch 1,
**dadurch gekennzeichnet,**
**dass** die Trennschicht (40) aus Kunststoff, insbesondere bestehend aus PTFE oder PEEK, ausgebildet ist.

5. Piezoaktormodul nach einem der Ansprüche 1 bis 4,
**dadurch gekennzeichnet,**
**dass** die Kontaktmittel (31, 32) als Anschlussdrähte ausgebildet sind, und dass die Verbindungen zwischen den Anschlussdrähten und den Kontaktflächen (33) als Schweißverbindungen (34) ausgebildet sind.

6. Piezoinjektor (100), umfassend einen Haltekörper (101) und ein in dem Haltekörper (101) angeordnetes Piezoaktormodul (10), das nach einem der Ansprüche 1 bis 5 ausgebildet ist.

## Claims

1. Piezo-actuator module (10), comprising an actuator base (16), an actuator head (18) and, arranged between the actuator base (16) and the actuator head (18), a piezo-actuator (20) comprising a multiplicity of electrode layers (21, 22), wherein the piezo-actuator (20) is adjacent to the actuator base (16) in relation to a longitudinal axis (11) of the piezo-actuator module (10), and wherein contact means (31, 32) are provided, which are led through the actuator base (16) and rigidly connected to contact pads (33) of the piezo-actuator (20), said contact pads being arranged at a distance (a) from the actuator base (16), wherein the piezo-actuator (20) has metallization layers (24; 24a) at the circumference of the piezo-actuator (20), said metallization layers being electrically conductively connected to the electrode layers (21, 22), wherein the metallization layers (24; 24a), on the side facing away from the piezo-actuator (20), are connected at least regionally to electrically conductive, flexible metal grids (25), wherein the metal grids (25) form the contact pads (33) and the contact pads (33) are arranged movably in the region of the contact means (31, 32) connected thereto,
**characterized**
**in that** a separating layer (40) is arranged at least in the region of each contact pad (33) between the metallization layer (24; 24a) and the metal grid (25), said separating layer preventing a connection between the metallization layer (24; 24a) and the metal grid (25).

2. Piezo-actuator module according to Claim 1,
**characterized**
**in that** the metallization layer (24a) has a cutout (37) in an axial region of overlap with the contact means (31, 32).

3. Piezo-actuator module according to Claim 1,
**characterized**
**in that** the metallization layer (24) is formed in an axial region of the piezo-actuator (20) which, in relation to the actuator base (16), is adjacent to the contact pad (33) and outside an axial region of overlap with the contact means (31, 32).

4. Piezo-actuator module according to Claim 1,
**characterized**
**in that** the separating layer (40) is formed from plastic, in particular consisting of PTFE or PEEK.

5. Piezo-actuator module according to any of Claims 1 to 4,
**characterized**
**in that** the contact means (31, 32) are formed as connecting wires, and in that the connections between the connecting wires and the contact pads (33) are formed as welding connections (34).

6. Piezo-injector (100), comprising a holding body (101) and a piezo-actuator module (10) configured according to any of Claims 1 to 5, said piezo-actuator module (10) being arranged in the holding body (101).

## Revendications

1. Module formant actionneur piézo-électrique (10) comprenant une base d'actionneur (16), une tête d'actionneur (18) et un actionneur piézo-électrique (20) disposé entre la base d'actionneur (16) et la tête d'actionneur (18) et constitué d'une pluralité de couches d'électrodes (21, 22), l'actionneur piézo-électrique (20) se raccordant à la base d'actionneur (16) par rapport à un axe longitudinal (11) du module formant actionneur piézo-électrique (10), et des moyens de contact (31, 32) étant prévus qui sont guidés à travers la base d'actionneur (16) et qui sont reliés rigidement à des surfaces de contact (33) de l'actionneur piézo-électrique (20) qui sont disposées à une distance (a) de la base d'actionneur (16), l'actionneur piézo-électrique (20) comportant des couches de métallisation (24 ; 24a) reliées de manière électriquement conductrice aux couches d'électrodes (21, 22) à la périphérie de l'actionneur piézo-électrique (20), les couches de métallisation (24 ; 24a) étant reliées, du côté opposé à l'actionneur piézo-électrique (20), au moins partiellement à des grilles métalliques flexibles (25) électriquement conductrices, et les grilles métalliques (25) formant les surfaces de contact (33), les surfaces de contact (33) étant disposées de manière mobile dans la zone des moyens de contact (31, 32) associés à celles-ci,
**caractérisé en ce que**
une couche de séparation (40) est disposée, au moins dans la zone de chaque surface de contact (33), entre la couche de métallisation (24 ; 24a) et la grille métallique (25), laquelle couche de séparation empêche une connexion entre la couche de métallisation (24; 24a) et la grille métallique (25).

2. Module formant actionneur piézo-électrique selon la revendication 1,
**caractérisé en ce que**
la couche de métallisation (24a) comporte un évidement (37) dans une zone de recouvrement axiale avec les moyens de contact (31, 32).

3. Module formant actionneur piézo-électrique selon la revendication 1,
**caractérisé en ce que**
la couche de métallisation (24) est formée dans une zone axiale de l'actionneur piézoélectrique (20), laquelle se raccorde, par rapport à la base d'actionneur (16), à la surface de contact (33) et, à l'extérieur d'une zone de recouvrement axiale, aux moyens de contact (31, 32).

4. Module formant actionneur piézo-électrique selon la revendication 1,
**caractérisé en ce que**
la couche de séparation (40) est formée à partir d'une matière plastique, en particulier est constituée de PTFE ou de PEEK.

5. Module formant actionneur piézo-électrique selon l'une des revendications 1 à 4,
**Caractérisé en ce que**
les moyens de contact (31, 32) sont réalisés sous la forme de fils de raccordement et **en ce que** les connexions entre les fils de raccordement et les surfaces de contact (33) sont réalisées sous la forme de connexions soudées (34).

6. injecteur piézo-électrique (100) comprenant un corps de maintien (101) et un module formant actionneur piézo-électrique (10) disposé dans le corps de maintien (101) et conçu selon l'une quelconque des revendications 1 à 5.
